# EUROPEAN PATENT APPLICATION

(11) **EP 1 670 080 A1**
(43) Date of publication of application: **14.06.2006**
(21) Application number: 05106009.3
(22) Date of filing: 01.07.2005
(51) Int. Cl.: H01L 51/40, H01L 51/56, C23C 14/35

(54) **Method of manufacturing organic light emitting device by using mirror shaped target sputtering apparatus**

(30) Priority: 08.12.2004 KR 2004103224
(71) Applicant: Samsung SDI Co., Ltd., Suwon-si Gyeonggi-do (KR)
(72) Inventor: Lee, Kyu-Sung, Gyeonggi-do (KR); Kim, Han-Ki, Samsung SDI Co., Ltd., Gyeonggi-do (KR); Kim, Do-Geun, Samsung SDI Co., Ltd., Gyeonggi-do (KR); Huh, Myung-Soo, Gyeonggi-do (KR); Jeong, Seok-Heon, Gyeonggi-do (KR)
(74) Representative: Hengelhaupt, Jürgen

(57) **Abstract**

A method of manufacturing an organic light emitting device by using a facing target sputtering apparatus is provided. The method includes forming a first electrode on a substrate; forming an organic film on the first electrode; and forming a second electrode on the organic film by using a facing target sputtering apparatus. Accordingly, an electrode film is formed on the organic light emitting device at a low temperature without deterioration of the electrode film due to plasma, it is possible to improve light emitting efficiency and electro-optical characteristics of the organic light emitting device.

## Description

### CROSS-REFERENCE TO RELATED PATENT APPLICATION

This application claims the benefit of Korean Patent Application No. 2004-103224, filed on December 8, 2004, in the Korean Intellectual Property Office, the disclosure of which is incorporated herein in its entirety by reference

### BACKGROUND OF THE INVENTION

### 1. Field of the Invention

The present invention relates to a method of manufacturing an organic light emitting device by using a facing target sputtering apparatus, and more particularly, to a method of manufacturing an organic light emitting device by using a facing target sputtering apparatus capable of forming an electrode or metal film on an organic film.

### 2. Description of the Related Art

In general, an organic light emitting device has excellent properties such as self-emission, a wide viewing angle, and a high response rate. The organic light emitting device such as an organic light emitting diode comprises a first electrode (an anode) and a second electrode (a cathode) including a hole transport layer (HTL), a light emitting layer, an electron transport layer (ETL), and so on formed on a glass substrate.

When a few voltage is applied between the anode and cathode, holes and electrons are generated from the anode and cathode, respectively. The holes and electrons are transported through the respective hole and electron transport layers and coupled in the light emitting layer. As a result, high-energy excitons are generated in the light emitting layer. When the excitons are transitioned from an excited state to a ground state, light emits with an energy corresponding to the energy difference between the excited and ground states. The light is used to display an image.

The organic light emitting devices are classified into bottom emitting type and top emitting type organic light emitting devices. In the bottom emitting type organic light emitting device, the light passes through the transparent anode made of a transparent material such as indium tin oxide (ITO) and emit from the substrate. The cathode is made of a metal such as Al. On the other hand, in the top emitting type organic light emitting device, the light passes through a transparent or semi-transparent cathode and emits from a protective film.

Conventionally, electrodes are formed on an organic film by using a DC/RF (direct current/radio frequency) sputtering process.

In case of using the conventional DC/RF sputtering process, high energy particles such as Ar ions collide with a target to form generate plasma. The high energy particles include neutral Ar, negative ions, positive ions, and thermal electrons. When the high energy particles are deposited on the organic film, a temperature of the organic film increases, so that the properties of the organic film may change. As a result, a leakage current flowing though the organic film between the two electrodes increases. In addition, in case of using the conventional DC/RF sputtering process, during the collision of the high energy particles on the substrate, thereby occurring phenomena for affecting the characteristics of the organic light emitting device. The phenomena include re-sputtering on a surface of the substrate, interfacial reaction, secondary particles generation, and so on.

On the other hand, in any one of the bottom and top emitting types, when the temperature of the transparent electrode is about 300 °C or more, the transparent electrode is crystallized. In order to maintain the specific characteristics of the transparent electrode, it is preferable that the transparent electrode have an amorphous property. However, in case of using the conventional DC/RF sputtering process, since the ion particles have a high energy, the temperature of the film increases over the 300 °C. As a result, the crystallization of the transparent electrode occurs. In order to prevent the crystallization of the transparent electrode, there is a need to reduce the process rate or to lower the energy of the ion particles. However, in case of using the conventional DC/RF sputtering process, it is difficult to reduce the process rate or to lower the energy of the ion particles.

### SUMMARY OF THE INVENTION

The present invention provides a method of manufacturing an organic light emitting device by using a facing target sputtering apparatus capable of forming an electrode or metal film on an organic film.

The present invention also provides a method of manufacturing an organic light emitting device capable of preventing deterioration in an organic film due to generation of plasma, preventing a leakage current from flowing through the organic film, and preventing deterioration in light emitting efficiency of an organic light emitting layer.

According to an aspect of the present invention, there is provided a method of manufacturing an organic light emitting device, comprising steps of: forming a first electrode on a substrate; forming an organic film on the first electrode; and forming a second electrode on the organic film by using a facing target sputtering apparatus.

In the aspect of the present invention, the first electrode may be formed by using the facing target sputtering apparatus. In addition, the first electrode may be made of an amorphous material. In addition, the first electrode may be made of one selected from a group consisting of Al, Ag, Mg, Ca, Cu, Au, Pt, ITO, IZO, AZO, GZO, GTO, and ATO.

In addition, the second electrode may be made of an amorphous material. In addition, the second electrode may be made of one selected from a group consisting of Al, Ag, Mg, Ca, Cu, Au, Pt, ITO, IZO, AZO, GZO, GTO, and ATO.

In addition, the facing sputtering apparatus may comprise two parallel targets disposed to face each other, wherein the substrate is disposed perpendicular to the two targets, wherein the facing sputtering apparatus performs a sputtering process including steps of: applying a power to the targets; forming a parallel magnetic field between the targets in a direction perpendicular to surface of the targets; and generating plasma by injecting a plasma generating gas into a space between the targets.

In addition, the sputtering process may be performed at a pressure of 0.1 ∼ 50 mTorr. In addition, the substrate may be maintained at a temperature of 20 ∼ 200 °C. In addition, the power may be in a range of 50 ∼ 5 kW.

In addition, the step of applying a power may comprise steps of: applying a first power of 50 - 500 W; and applying a second power of 500 ∼ 5 kW. In addition, a power density applied to the targets may be about 0.001 W/cm². In addition, the two targets may be made of different materials. In addition, a thickness of the first and second electrodes may be in a range of 20 ∼ 1,000 nm.

### BRIEF DESCRIPTION OF THE DRAWINGS

The above and other features and advantages of the present invention will become more apparent by describing in detail exemplary embodiments thereof with reference to the attached drawings in which:
FIG. 1 is a schematic view of a facing target sputtering apparatus used to manufacturing an organic light emitting device according to present invention;
FIG. 2 is a flow-chart of a method of manufacturing an organic light emitting device according to the present invention;
FIG. 3 is a flow-chart of a facing target sputtering process in a method of manufacturing an organic light emitting device according to the present invention;
FIG. 4 is a flow-chart of a process of forming an electrode on a substrate in a method of manufacturing an organic light emitting device according to the present invention;
FIG. 5 is a graph showing results of XRD (X-ray diffraction) performed on Al electrodes formed by using a facing target sputtering process according to the present invention and a conventional DC/RF sputtering process;
FIG. 6 is a graph showing results of XRD performed on ITO films formed by using a facing target sputtering process according to the present invention and a conventional DC/RF sputtering process;
FIG. 7A is an Scanning Electron Microscopy (SEM) image obtained from an Al thin film formed by using a conventional DC/RF sputtering process;
FIG. 7B is an SEM image obtained from an Al thin film formed by using a facing target sputtering process according to the present invention;
FIG. 8A is an Atomic Force Microscopy (AFM) image obtained from an ITO transparent film formed by using a conventional DC/RF sputtering process; and
FIG. 8B is an AFM image obtained from an ITO transparent film according to the present invention.

### DETAILED DESCRIPTION OF THE INVENTION

Now, embodiments according to the present invention will be described in detail with reference to the accompanying drawings.

In the embodiment of the present invention, a facing target sputtering apparatus is used to form an electrode film on an organic film. In the facing target sputtering apparatus, two targets 200 and 210 are disposed to face each other. A magnetic field B is generated in a space between the targets 200 and 210 in a direction perpendicular to surfaces of the targets 200 and 210. A plasma generating gas (hereinafter, referred to as a process gas) is injected in the magnetic field B to generate a high-density plasma.

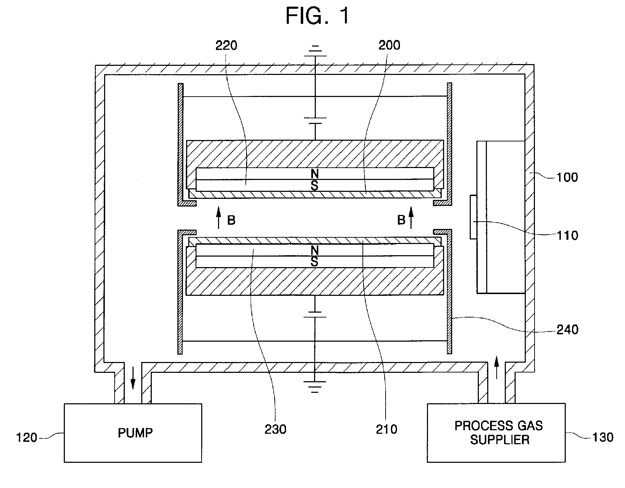

Referring to FIG. 1, the facing target sputtering apparatus comprises: a chamber 100; a process gas supplier 130 for supplying a process gas (for example, a mixture gas of argon and oxygen), into the chamber 100; and a pump 120 for generating a low pressure vacuum state of the chamber 100. Two targets 200 and 210 are disposed to face each other in the chamber 100. Negative voltage power sources are individually connected to the targets 200 and 210. Alternatively, a single negative voltage power source may be connected to the targets 200 and 210 in parallel.

The magnetic field B is uniformly formed between the targets 200 and 210 in a direction from the target 210 to the target 200. In addition, a voltage distribution between the targets 200 and 210 is as follows. A uniform low positive voltage is generated in a localized central region between the targets 200 and 210. The voltage decreases by a predetermined slope from the positive voltage of the central region to negative voltages of the targets 200 and 210.

Flat magnets 220 and 230 are disposed behind the targets 200 and 210 to generate the uniform magnetic field. More specifically, the opposite magnetic poles of the flat magnets 220 and 230 are disposed to face each other. Here, a plurality of pellet magnets are arrayed to constitute the magnets 220 and 230. Alternatively, a plurality of bar magnets may be arrayed to constitute the magnets 220 and 230. Otherwise, electromagnets may be used as the magnets 220 and 230 in order to control the magnetic field intensity.

In a case where a scanning sputtering source including the targets 200 and 210 is provided, the sputtering source scans a large-sized substrate 110 (where an organic film including a light emitting layer is formed) to form an electrode film on a surface of the substrate 110. Two shields 240 are disposed to surround the two respective targets 200 and 210 of the sputtering source in order to prevent a target material of the targets 200 and 210 from deviating from the substrate 110, so that the target material can be directed only toward the substrate 110. Therefore, the sputtering source serves as a sputtering gun for emitting the target material through a slit, that is, an opening between the two shields 240. A size of the slit can be adjusted in a predetermined range.

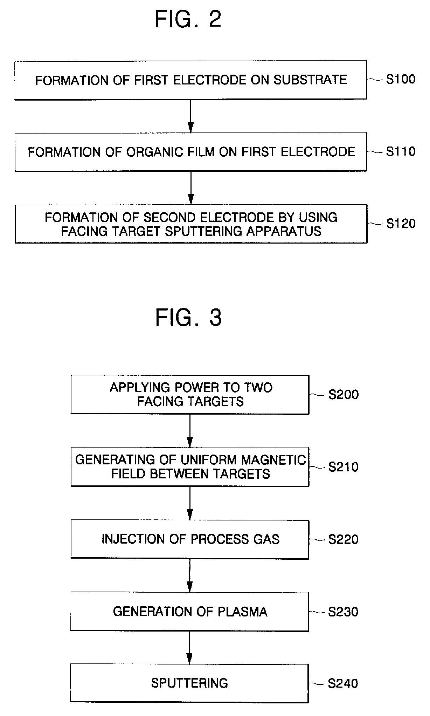

Now, operations of the facing target sputtering apparatus will be described with reference to FIG. 3. Firstly, an internal pressure of the chamber 100 is maintained at about 10⁻¹⁵ Torr or less (that is, a base pressure) by using the pump 120. Next, a power is supplied to the targets 200 and 210 by using aforementioned power supplier (S200). Here, the supplied power is preferably in a range of 50 ∼ 5 KW. Therefore, the uniform magnetic field B is generated between the targets 200 and 210 (S210).

Next, a process gas, that is, a mixture gas of argon and oxygen, is injected into the chamber 100. Due to the injection of the process gas, the internal pressure of the chamber 10 increases. In order to perform a proper process, the internal pressure of the chamber 100 is preferably maintained in a range of 0.1 ∼50 mTorr by using the pump. In addition, a power density in the chamber 100 is preferably maintained at 0.001 W/cm² or more.

As a result, plasma is generated (S230). In order to increase a plasma generating efficiency, the process gas is injected from a rear side of the sputtering source (that is, the sputtering gun) to flow toward the slit of the sputtering source (that is, the outlet of the emitting target material of the targets 200 and 210).

Due to the electric and magnetic fields in the chamber 100, the Lorentz force is exerted on electrons in the plasma, so that the electrons rotate on a plane perpendicular to the magnetic field generated between the magnets 220 and 230 while reciprocally moving between the targets 200 and 210. As a result, the electrons have helical trajectories.

Similarly, other charged particles including ions rotate on the plane perpendicular to the magnetic field and reciprocally move between the targets 200 and 210. As a result, high energy charged particles can be confined in the plasma.

Charged particles generated by sputtering positive ions on the target 200 are accelerated with a high energy toward the facing target 210. Since the charged particles move in a direction perpendicular to the substrate 110, the charged particles do not affect the substrate 110 where the organic film is formed. Only the neutral particles having a relatively low energy generated from the target material of the targets 200 and 210 diffusively emit toward the substrate 110 or the organic film on the substrate 110 to form the electrode thin film thereon.

Unlike a conventional DC/RF sputtering process using high energy particles, according to the present invention, it is possible to prevent the organic light emitting device from deteriorating due to the collision of the high energy particles. In addition, since there is no collision of the high energy particles, there is no need for a separate substrate cooling system to maintain the substrate 110 at a room temperature. As a result, it is possible to minimize thermal deterioration in the substrate 110, particularly, the organic thin film on the substrate 110.

Referring to FIG. 2, a method of manufacturing an organic light emitting device by using the facing target sputtering apparatus is as follows. A first electrode is formed on a substrate 110 (S100). Next, an organic film is formed on the first electrode (S110). Next, a second electrode is formed on the organic film (S210).

In the step S210, the aforementioned facing target sputtering apparatus is used to form the second electrode on the organic film. In addition, the facing target sputtering apparatus may be used to form the first electrode.

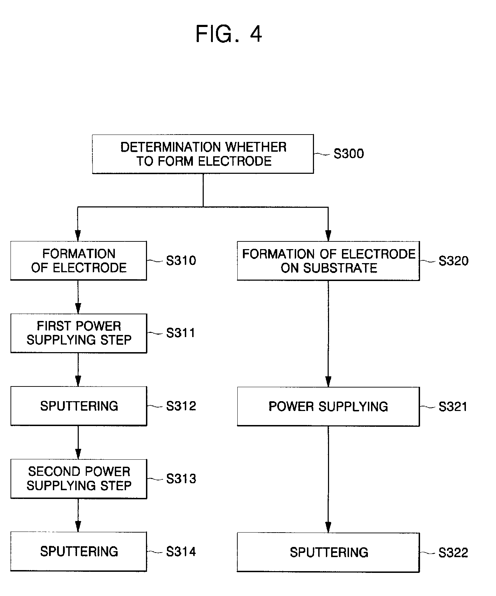

In order to reduce damage to the organic film during the step 210 of forming the second electrode, process conditions can be adjusted. Referring to FIG. 4, a single process or two processes may be performed depending on the presence or absence of the electrode formed on the organic film.

More specifically, it is determined whether or not the electrode is to be formed on the organic film (S300). In a case where the electrode is to be formed on the organic film (S310), a first power supplying step S311 is performed to supply a first power for an initial process. Next, a sputtering step S312 is performed to form an electrode film having a predetermined thickness. Next, a second power supplying step S313 is performed to supply a second power which is higher than the first power. Next, another sputtering step 314 is performed.

According to the method of the present invention, the first sputtering process is performed to form the electrode film while the organic film is protected. Just after the electrode film having a predetermined thickness is formed, the second sputtering process is performed to form an electrode having a necessary thickness. As a result, it is possible to improve process efficiency.

The first power supplied in the first power supplying step S311 is preferably in a range of 50 ∼ 500 W. The second power supplied in the second power supplying step S312 is preferably in a range of 500 ∼ 5 kW. Although a substrate separate cooling system is not a requisite component, the temperature of the substrate is preferably maintained in a range of 20 ∼ 200 °C during the formation of the substrate.

Same or different target materials are used depending on whether the electrode formed by the method is a transparent electrode or a metal film. Therefore, various types of transparent electrodes and metal films can be formed. According to the present invention, the target material used to form the electrode or film includes Al, Ag, Mg, Ca, Cu, Au, Pt, ITO (Indium Tin Oxide), IZO (Indium Zinc Oxide), AZO (Aluminum doped Zinc Oxide), GZO (Gallium Zinc Oxide), GTO (Gallium Tin Oxide), and ATO (Antimony Tin Oxide). The thickness of the electrode or film is in a range of 20 - 100 nm.

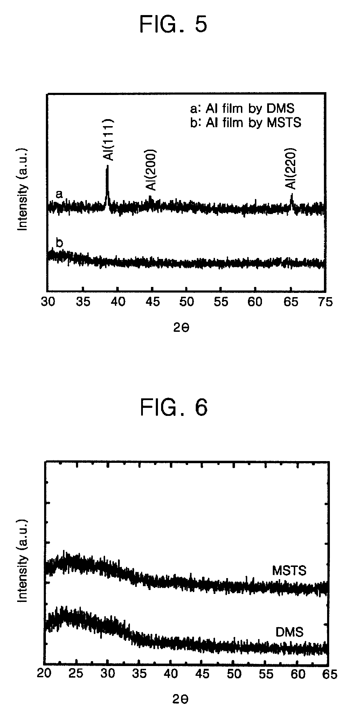

FIG. 5 is a graph showing results of XRD (X-ray diffraction) performed on Al electrodes formed by using a facing target sputtering process according to the present invention and a conventional DC/RF sputtering process. FIG. 6 is a graph showing results of XRD performed on ITO films formed by using a facing target sputtering process according to the present invention and a conventional DC/RF sputtering process.

In case of using the conventional DC/RF sputtering process, the internal pressure of the chamber is 5 mTorr; the power is DC 200W; the distance between the target is 10 cm; the process gas is Ar; and the thickness of the film formed on a glass substrate is 1,000 nm. On the other hand, in case of using the facing target sputtering process according to the present invention, the internal pressure of the chamber is 5 mTorr; the power is DC 1 kW; the distance between the target is 20 cm; the process gas is Ar; and the thickness of the film formed on a glass substrate is 1,000 nm.

In case of using the conventional DC/RF sputtering process, the Al and transparent electrode films have a poly-crystalline structure where there are peaks. On the other hand, in case of using the facing target sputtering process according to the present invention, the Al and transparent electrode film has an amorphous structure where there is no crystalline peak.

The difference between the structures of the films formed by using the two processes result from a localized temperature difference of the substrates. In case of using the conventional DC/RF sputtering process, the temperate of the substrate increases due to the collision of the particles having a high energy, so that relatively large-sized particle grains constitute the poly-crystalline structure.

However, in case of using the facing target sputtering process according to the present invention, it is possible to prevent the particles having a high energy form colliding, so that the temperature of the substrate can be maintained at a room temperature. As a result, the film having the amorphous structure can be obtained. In other words, in case of using the facing target sputtering process, the particles having a high energy cannot affect the formation of the film.

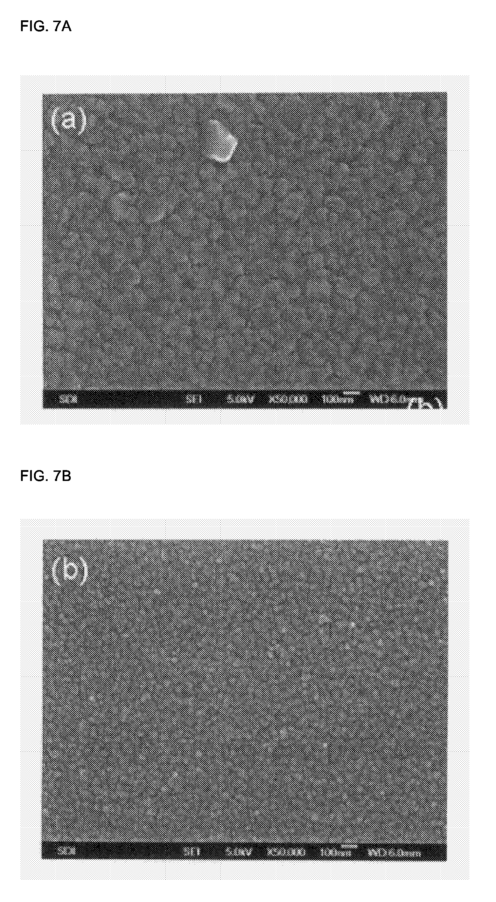

FIG. 7A is a SEM (Scanning Electron Microscopy) image obtained from an Al thin film formed by using a conventional DC/RF sputtering process. FIG. 7B is a SEM image obtained from an Al thin film formed by using a facing target sputtering process according to the present invention.

Referring to SEM images of FIGS. 7A and 7B, the results of XRD of FIGs. 5 and 6 can be visually verified. Here, the electrode film is formed on the organic film of a front-emitting-type organic light emitting device. The organic light emitting device comprises an electron injecting layer (EIL), an electron transport layer (ETL), a hole blocking layer (HBL), a hole transport layer (HTL), a hole injecting layer (HIL), an ITO layer, and a glass substrate.

As seen in the result of XRD of FIGs. 5 and 6, according to the facing target sputtering process of the present invention, the Al film is constructed with fine particles in comparison to the Al film formed by using the conventional DC/RF sputtering process. In the present invention, since the temperature of the substrate is low, the temperature and energy are not sufficient to grow Al grains.

Sizes of Al particles grown by using the facing target sputtering process are ten times less than sizes of Al grains grown by using the conventional DC/RF sputtering process. Therefore, it can be understood that, since the collision of the high energy particles can be prevented, the electrode film is formed without deterioration due to the plasma in case of using the facing target sputtering process for forming the Al film.

In general, it is difficult to form an amorphous film without deterioration due to the plasma during the DC/RF sputtering process. However, in case of using the facing target sputtering process according to the present invention, it can be seen that the substrate is always maintained at a temperature of 60 °C or less, which can be detected with a temperature tape. As a result, according to the facing target sputtering process of the present invention, it is possible to form the amorphous metal film on the organic film of the organic light emitting device at the temperature where the organic film is not affected.

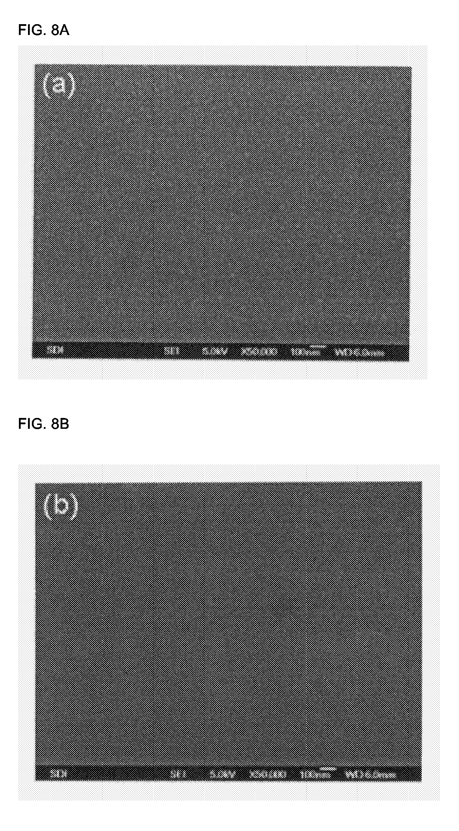

FIG. 8A is an AFM (Atomic Force Microscopy) image obtained from an ITO transparent film formed by using a conventional DC/RF sputtering process; and FIG. 8B is an AFM image obtained from an ITO transparent film according to the present invention. In case of using the conventional DC/RF sputtering process, the internal pressure of the chamber is 5 mTorr; the power is DC 300W; the distance between the target is 10 cm; the process gas is a mixture gas of Ar and oxygen; and the thickness of the film formed on a glass substrate is 1,000 nm. On the other hand, in case of using the facing target sputtering process according to the present invention, the internal pressure of the chamber is 5 mTorr; the power is DC 1 kW; the distance between the target is 20 cm; the process gas is a mixture gas of Ar and oxygen; and the thickness of the film formed on a glass substrate is 1,000 nm.

Similar to the results of XRD of FIGs. 7A and 7B, it can be seen from the AFM images of FIGs. 8A and 8B that the surface of the ITO film grown by using the facing target sputtering process is not rougher than the surface of the ITO film grown by using the conventional DC/RF sputtering process. More specifically, an RMS (root mean square) surface roughness of the ITO film grown by using the facing target sputtering process is 2.3 nm, while an RMS surface roughness of the ITO film grown by using the DC/RF sputtering process is 7.8 nm.

According to a facing target sputtering apparatus of the present invention, since an electrode film can be formed on an organic film of an organic light emitting device without deterioration due to plasma, it is possible to improve light emitting efficiency and electro-optical characteristics of the organic light emitting device. In addition, since process conditions can be adjusted in a plurality of processes for forming the electrode film, it is possible to improve the electro-optical characteristics and lifetime of the organic light emitting device.

In addition, since a high-quality transparent electrode can be formed on the organic film, it is possible to manufacture a front-emitting-type organic light emitting device having excellent properties.

In a method of manufacturing an organic light emitting device according to the present invention, since a high-density plasma is generated between two targets to reduce deposition time for the electrode film, it is possible to improve process efficiency. In addition, it is possible to reduce production costs in comparison to a conventional method.

In addition, according to the present invention, since the film can be formed at a low temperature, it is possible to easily manufacture a flexible organic light emitting device using a conventional heat-vulnerable substrate.

While the present invention has been particularly shown and described with reference to exemplary embodiments thereof, it will be understood by those skilled in the art that various changes in form and details may be made therein without departing from the spirit and scope of the present invention as defined by the appended claims.

## Claims

1. A method of manufacturing an organic light emitting device, comprising steps of:
forming a first electrode on a substrate;
forming an organic film on the first electrode; and
forming a second electrode on the organic film by using a sputtering process while the substrate is maintained at a temperature of 20 ∼ 200 °C.

2. The method according to claim 1, wherein the first electrode is formed by using a sputtering process while the substrate is maintained at a temperature of 20 ∼ 200 °C.

3. The method according to claim 1, wherein the first and second electrodes are made of an amorphous material.

4. The method according to claim 3, wherein the first and second electrodes are made of one selected from a group consisting of Al, Ag, Mg, Ca, Cu, Au, Pt, ITO, IZO, AZO, GZO, GTO, and ATO.

5. The method according to claim 1,
wherein the two parallel targets are disposed to face each other,
wherein the substrate is disposed perpendicular to the two targets, and
wherein the sputtering process is performed by steps of:
applying a power to the targets;
forming a parallel magnetic field between the targets in a direction perpendicular to surface of the targets; and
generating plasma by injecting a plasma generating gas into a space between the targets.

6. The method according to claim 5, wherein the sputtering process is performed at a pressure of 0.1 ∼ 50 mTorr.

7. The method according to claim 5, wherein the power is in a range of 50 ∼ 5 kW.

8. The method according to claim 7, wherein the step of applying a power comprises steps of:
applying a first power of 50 ∼ 500 W; and
applying a second power of 500 ∼ 5 kW.

9. The method according to claim 5, wherein a power density applied to the targets is about 0.001 W/cm².

10. The method according to claim 5, wherein the two targets are made of different materials.

11. The method according to claim 5, wherein a thickness of the first and second electrodes is in a range of 20 ∼ 1,000 nm.

12. A method of manufacturing an organic light emitting device, comprising steps of:
forming a first electrode on a substrate;
forming an organic film on the first electrode;
applying a power to two targets, wherein the two parallel targets are disposed to face each other on the organic film;
forming a parallel magnetic field between the targets in a direction perpendicular to surfaces of the targets;
generating plasma by injecting a plasma generating gas into a space between the targets;
forming a second electrode by using a sputtering process while the substrate is maintained at a temperature of 20 ∼ 200 °C, wherein the substrate is disposed perpendicular to the two targets.

13. The method according to claim 12, wherein the second electrodes is made of an amorphous material.

14. The method according to claim 12, wherein the second electrode is made of one selected from a group consisting of Al, Ag, Mg, Ca, Cu, Au, Pt, ITO, IZO, AZO, GZO, GTO, and ATO.

15. The method according to claim 12, wherein the sputtering process is performed at a pressure of 0.1 ∼ 50 mTorr.

16. The method according to claim 12, wherein the power is in a range of 50 ∼ 5 kW.

17. The method according to claim 16, wherein the step of applying a power comprises steps of:
applying a first power of 50 ∼ 500 W; and
applying a second power of 500 ∼ 5 kW.

18. The method according to claim 12, wherein a power density applied to the targets is about 0.001 W/cm².

19. The method according to claim 12, wherein the two targets are made of different materials.

20. The method according to claim 12, wherein a thickness of the first and second electrodes is in a range of 20 ∼ 1,000 nm.
